# EUROPEAN PATENT SPECIFICATION

(11) **EP 2 866 036 B1**
(45) Date of publication and mention of the grant of the patent: **10.08.2016**
(21) Application number: 13190519.2
(22) Date of filing: 28.10.2013
(51) Int. Cl.: G01R 1/04, H05K 7/10

(54) **Screwless contact spring exchange**
Schraubenloser Kontaktfederaustausch
Échange de ressort de contact sans vis

(43) Date of publication of application: 29.04.2015
(73) Proprietor: Multitest elektronische Systeme GmbH, 83026 Rosenheim (DE)
(72) Inventor: Leikermoser, Volker, 83229 Aschau im Chiemgau (DE); Staniszewski, Gerald, 83115 Neubeuern (DE)
(74) Representative: Dilg, Haeusler, Schindelmann Patentanwaltsgesellschaft mbH

(56) References cited:
- WO-A1-2008/062980
- US-A- 5 295 841
- US-A- 5 573 408
- US-A1- 2007 072 479
- US-A1- 2010 120 269

## Description

### FIELD OF THE INVENTION

The invention relates to a contact spring block for a sequential test of electronic components. Further, the invention relates to a contact socket for a sequential test of electronic components. Furthermore, the invention relates to a method of changing contact springs of a contact spring block. Moreover, the invention relates to a method of changing the contact springs of a contact socket.

### BACKGROUND OF THE INVENTION

Contact sockets are usually made of several parts like contact springs, contact spring blocks in which the contact springs are arranged, and a socket frame which holds the contact spring blocks. The contact springs have usually an elastic section and a contact tip at an outer end by which pads or leads of electronic components are contacted. During a test of many electronic components (also "DUTs") the complete equipment may become more and more polluted. In particular, contacting by the contact tips may be hindered or become impossible when dirt from the lead material is deposited on the contact tips. Therefore, the parts of the contact socket which are subjected to this process are usually exchangeable. Usually the contact spring blocks are integrally formed and entirely screwed on a socket frame so that exchanging of the complete contact spring block may restore the functionality of the contact socket. Due to extreme small dimensions of the distances between contact springs (also called "pitches" on the DUTs) these contact spring blocks must be manufactured with extreme high accuracy and therefore pricing is high. An implementation of an electrical edge connector is disclosed in US 5,573,408 A.

### OBJECT AND SUMMARY OF THE INVENTION

There may be a need to reduce the cost for maintenance of a contact socket. One further object may be to provide an easy to maintain contact socket which works highly reliable.

In order to achieve the object defined above, a contact spring block, a contact socket, a method of changing the contact springs of a contact spring block and a method of changing the contact springs of a contact socket are provided according to the claims 1 to 15.

According to an embodiment of the invention a contact spring block for a sequential test of electronic components comprises: a base block, a group of single contact springs, and a clip-on device, wherein the group of single contact springs is clamped and aligned when the clip-on device is clipped to the base block.

Each contact spring of the group of single or individual contact springs may comprise a contact tip. The group of single contact springs may be firmly clamped between the base block and the clip-on device when the clip-on device is clipped to the base block. The group of single contact springs may be clamped directly or non-directly between the base block and the clip-on device.

The expression "sequential test" may particularly denote that a test is usually carried out with one DUT at a time. A test may be an electronic check under different environmental conditions such as defined temperature, pressure, acceleration, rotation etc. The term "electronic component" may denote a so called DUT (device under test) which is a product of the backend in the semiconductor production. Thus, the expression "sequential test of electronic components" may particularly denote an electronic examination of ICs (integrated circuits) which need a functional proof of their quality under determined conditions. The test may be carried out for one electronic component at a time and may be repeated for further electronic components (DUTs). The equipment which does the sequential test of the electronic components is usually called automated test equipment (ATE).

The expression "group of single contact springs" may denote a certain number (two, three, four, five or more) of electrically conductive elastic units which are used to transfer electrical signals in any direction between a tester and the contact pads of the DUT. The expression "contact tip" may particularly denote the open ends of the contact springs which are mechanically pressed to contact portions (the contacts, contact pads or grid balls) of the DUT. The single contact springs may have a typical S-form or any form which is used to elastically contact to the contact pads of the DUT.

The term "contact spring block" may particularly denote a composed device in which a plurality of contact springs are fixed and aligned so that the contact spring block may comprise a required number of contact tips in order to contact to the necessary number of contact portions of the DUT. A contact spring block may comprise one contact spring for each contact pad of the DUT. Moreover, the contact spring block may comprise more contact springs for each contact pad of the DUT to improve the contact quality or to enable a so called Kelvin contact which is used to derive the quality of the electrical contact.

The term "base block" may denote a central device of the contact spring block. Hence, the base block is a part of the contact spring block. The contact springs may be aligned and fixed to the base block. The term "clip-on device" may particularly denote a counter piece of the base block so that the contact springs are aligned and mutually fixed by an engagement of the base block and the clip-on device. The term "clipped" may particularly denote "to clasp, fasten, or secure with a clip". Hence, the clip-on device is fastened to the base block by clipping the clip-on device to the base block. The term "clamped" may particularly denote "to hold tightly" or "to fasten with or as if with a clamp". A "clamp" may particularly denote a device designed to bind or to press two or more parts together so as to hold them firmly. "Clamping" means that any of various instruments or appliances having parts are brought together for holding or compressing something. As a consequence these parts may be the base block and the clip-on device which firmly hold the group of contact springs together.

The term "align" may particularly denote "to be in or come into precise adjustment or correct relative position". As a consequence of clamping the single contact springs are in the proper positioning or state of adjustment in relation to each other.

The expression that the "the group of single contact springs is clamped by clipping clip-on device to the base block" may denote that the single contact springs are directly or non-directly fixed and held tightly when the clip-on device is clipped to the base block.

According to a further embodiment of the invention a contact socket comprises a number (for instance one, two, three or four) of contact spring blocks comprising the features of the described contact spring block. Each of the contact spring blocks may be arranged in a mounting position on a side section of the contact site.

In particular, the contact spring blocks are arranged on each side, of the four sides of the contact socket. "Contact site" usually denotes the central area of the contact socket in which the electronic components are pressed so that the contact portions of the electronic components and the contact tips of the contact socket match.

A contact spring block may be screwed into the contact socket so that the clip-on device is pressed against a rigid part of the contact socket and is prevented from falling off. In particular, the clip-on device is pressed against the mounting position of the contact socket, so that the clip-on device cannot be clipped off when the contact spring block is mounted on the contact socket in the mounting position.

According to another embodiment of the invention a method of changing contact springs of a contact spring block, in particular a contact spring block according to an embodiment of the invention, the method comprising:
- Removing a clip-on device from a base block, wherein in particular the clip-on device and the base block are part of the contact spring block,
- Removing a first contact spring of a group of single contact springs off the contact spring block and putting a second contact spring in the position of the first contact spring,
- Clipping the clip-on device to the base block so that the group of single contact springs comprising the second contact spring is clamped.

The first and the second contact springs are usually contact springs of the same type. Hence, the first and the second contact springs are members of the group of single contact springs or are members of a further group of single contact springs. If the first and second contact spring is of the group of single contact springs then both are of the first contact spring type or both are of the second contacts spring type. In particular, the first contact spring may be damaged or polluted, and the second contact spring may be a new one. According to still another embodiment of the invention a method of changing contact springs of a contact spring block is provided wherein the method applies the above described method of changing the contact springs of a contact spring block, and furthermore comprises:
- Removing the contact spring block comprising the first contact spring from a mounting position of a contact socket,
- Putting the contact spring block comprising the second contact spring in the mounting position of the contact socket.

In particular, the removing of the contact spring block may be performed before the first contact spring is removed and/or the putting of the contact spring block is performed after the second contact spring is put in the position of the first contact spring. Removing the first contact spring block may comprise removing the first and second screws which fasten the first contact spring block with the clip-on device orientated in the direction to the area of the mounting position. Putting the second contact spring block in the mounting position may comprise that the clip-on device is prevented from falling off since the clip-on device is orientated towards the mounting position. Further, putting the second contact spring block in the mounting position may comprise that the clip-on device is pressed against the mounting position. Hence, the clip-on device is screwed to the mounting position so that it is hindered or blocked from falling of the contact spring block.

According to yet still another embodiment of the invention a method of changing contact springs of a contact socket comprising at least one contact spring block according to an embodiment of the invention, is provided, wherein the method comprises:
Removing a first contact spring block according to an embodiment of the invention from a mounting position of the contact socket; and
Putting a second contact spring block according to an embodiment of the invention in the mounting position of the contact socket.

According to an exemplary embodiment of the contact spring block, the group of single contact springs comprises a first subgroup of a first contact spring type having a first alignment pin. Further, the group of single contact springs comprises a second subgroup of a second contact spring type having a second alignment pin. At least one single contact spring of the first type or of the second type comprises a contact tip. A first type contact spring and a second type contact spring are clamped adjacently and the distance from the contact tip to the first alignment pin is smaller than the distance to the second alignment pin.

In particular, a first type contact spring and a second type contact spring may be clamped adjacently to each other onto the base block. The term "subgroup" may particularly denote a number of units being smaller than the number of the units of the group. The expression "first contact spring type" may particularly denote the form of a contact spring which is different from a "second contact spring type". The expression "first type contact spring" may denote an abbreviated expression for "contact spring of the first type" or "contact spring of the subgroup of the first contact spring type".

The term "adjacent" may particularly denote in this context that two contact springs are positioned directly or next to each other so that no other contact spring is between the two (contact springs). As a consequence, each of the two adjacently arranged contact springs comprises one alignment pin and the two alignment pins are positioned beside each other and no further contact spring is in between. However, the adjacent contact springs may be electrically isolated from each other. Any of the contact springs may be clamped so that the contact springs are electrically isolated by an air gap or parts, such as grooves, of the contact spring block.

Further, the two alignment pins are located on the contact springs so that one alignment pin is nearer to the contact tips than the other alignment pin. The first and second alignment pins may be located near to the elastic section of the contact spring.

According to an exemplary embodiment the contact spring block may further comprise: a clip plate having a first alignment hole and a second alignment hole wherein the first alignment hole engages with the first alignment pin and the second alignment hole engages with the second alignment pin.

In particular, the engagement may occur when the clip-on device is clipped to the base block. For example, the clip plate may be a portion or part of the clip-on device. The expression "first/second alignment hole" may denote "alignment hole of a first/second type" or "alignment hole in a first/second position". The term "clip plate" may particularly denote an integral part of the clip-on device. The clip-on device may comprise a clip plate having a first aligning hole and a second aligning hole. The expression "first aligning hole" and "second aligning hole" may particularly denote a different position of an opening of the clip plate rather than a different form of the opening. The first and second aligning holes may each engage with the first and second alignment pin, respectively. By the engagement of the aligning hole and the alignment pin the contact spring may be clamped and be held tightly in a determined position. The engagement of the aligning holes and the alignment pins may be a consequence of clipping the clip-on device to the base block. The contact springs may be aligned or centered so that the contact tips of the first and second contact springs are aligned in a straight row whereas the aligning holes and the alignment pins show a "zig-zag" pattern. The clip plate may clamp the contact springs near to the elastic portion of the contact springs.

According to an exemplary embodiment of the contact spring block, the base block comprises a clip-in groove, and the clip-on device comprises a retaining clip having a hook-like projection. The clip-on device and the base block are clipped together by an engagement of the clip-in groove and the hook-like projection.

The term "retaining clip" may particularly denote a part of the clip-on device. The retaining clip may comprise a hook or a hook-like projection which engages with a clip-in groove of the base block in a clip-like connector. Clipping the clip-on device to the base block may form a clip-type connector. The hook-like projection of the retaining clip and the clip-in groove of the base block may have a tongue and groove function.

According to an exemplary embodiment of the contact spring block, the base block comprises a further clip-in groove, and the clip-on device comprises a further retaining clip having a further hook-like projection. The clip-on device and the base block are clipped together by an engagement of the further clip-in groove and the further hook-like projection.

The clip mechanism may be more balanced if there are two clip-in grooves and two retaining clips so that the clamp force is separated to two retaining clips being distanced from each other.

According to an exemplary embodiment of the contact spring block, the retaining clip and the further retaining clip extend outwardly from opposite side sections of the clip plate.

In particular, the expression "opposite" may particularly denote that the retaining clip and the further retaining clip are arranged on opposite sides of the group of single contact springs when the clip-on device is clipped to the base block. That is, the group of single contact springs may be arranged between the retaining clip and the further retaining clip. The expression "outwardly" may particularly denote a direction which points away from the clip plate, e.g. is normal to the clip plate. In one embodiment, one retaining clip may extend outwardly from the clip plate rectangular so that the clip-on device has an L-shape with respect to this retaining clip. The other retaining clip may extend from the clip plate rectangular on the opposite side of the clip plate so that the clip-on device has the form of a yoke, that is a double L-shape.

According to an exemplary embodiment the first aligning hole and the second aligning hole are located between the retaining clip and the further retaining clip.

The clip mechanism may be more balanced when the functional parts like the alignment holes and pins are located between the clamp force exerting retaining clips.

According to an exemplary embodiment of the contact spring block the clip-on device is integrally formed from one piece and comprises at least two of the group of the clip plate, the retaining clip and the further retaining clip.

The clip-on device may be an integral plastic part comprising the clip plate and the retaining clip. The clip-on device may be integrally formed and may comprise the retaining clip and the further retaining clip. The clip-on device may be integrally formed from a plastic part comprising the clip plate, the retaining clip and the further retaining clip.

According to an exemplary embodiment of the contact spring block the clip-on device is integrally formed from one piece. The integrally formed clip-on device may then comprise at least two elements of the group consisting of a clip plate, a retaining clip and a further retaining clip, wherein the clip plate, and/or the retaining clip and/or the further retaining clip may be formed according to one of the above described embodiments.

According to an exemplary embodiment of the contact spring block the base block comprises a chamfer by which the retaining clip is pre-stressed when clipping the clip-on device to the base block.

To make it easy to clip the clip-on device to the base block, the base block may comprise a chamfer or in other words "a beveled edge". The retaining clip may glide (or slide) over the chamfer while being pre-stressed and then the hook-like projection of the retaining clip may at least engage with the clip-in groove of the base block. According to the engagement of the hook-like projection and the clip-in groove a clamp force may hold the retaining clip and the base block together tightly so that the contact springs are clamped. According to an exemplary embodiment of the contact spring block, the base block comprises a mounting pin. The clip-on device may comprise a clip mounting hole, wherein the clip-on device is fixed by an engagement of the mounting pin and the clip mounting hole in a direction perpendicular to the clamp force. For example, the clip-on device may be fixed to the base block by the engagement of the mounting pin and the clip mounting hole, wherein the fixing may in particular be in a direction perpendicular to a clamp force which may be affected by clamping the clip-on device to the base block.

In particular, the clip-on device is fixed to the base block by the engagement of the mounting pin and the clip mounting hole in a direction perpendicular to a clamp force when the clip-on device is clipped to the base block.

According to an exemplary embodiment the contact spring block comprises a further group of, in particular single, contact springs and a distance plate, wherein the distance plate is arranged between the group of contact springs and the further group of contact springs.

For a so called "Kelvin contact" two groups of contact springs may be arranged one above the other so that the two groups are electrically isolated. The group of contact springs and a further group of contact springs may be arranged above each other in relation to the elastic movement. For each of the groups having a certain number of contact springs, the contact springs are arranged in a row, side by side to each other. A distance plate in between the two groups may electrically isolate the two groups of single contact springs. According to an exemplary embodiment of the contact spring block, the distance plate comprises a distance plate mounting hole, wherein the distance plate is fixed by an engagement of the mounting pin and the distance plate mounting hole.

In particular, the distance plate is fixed to the base block by the engagement of the mounting pin and the distance plate mounting hole in a direction perpendicular to a clamp force when the clip-on device is clipped to the base block.

The mounting pin extending from the base block may engage with the distance plate mounting hole and the clip mounting hole so that the distance plate and the clip-on device both are secured against shifting perpendicular to the clamp force.

### Figures

Fig. 1A A schematic view of an automated test equipment (ATE)
Fig. 1B A schematic view of a contact unit holder (CUH)
Fig. 2 A perspective view of a contact socket and a contact spring block, and a plan view of the contact socket
Fig 3 The perspective view of the contact spring block and an exploded view of the contact spring block
Fig. 4 A twisted perspective view of the contact spring block with the clip-on element above
Fig. 5 A cross-sectional view of the contact socket
Fig 6 A cross-sectional view of a clip type connector

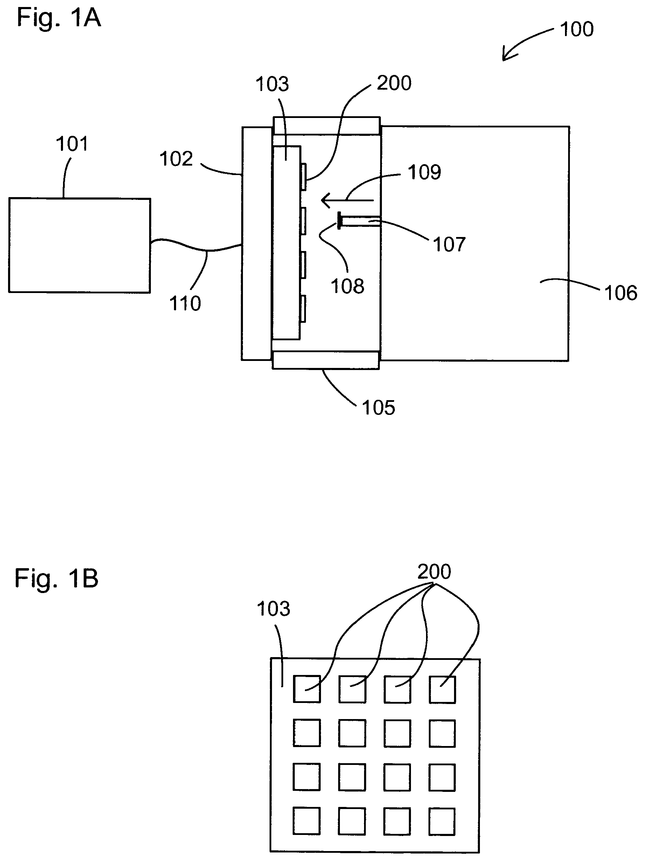

Fig. 1A shows a schematic view of automated test equipment (ATE) 100. An electronic component (DUT) 108 is pressed in a contacting direction 109 into a contact socket 200 so that electronic signals can be generated and transmitted via a tester cable 110 between a tester 101 and the DUT 108. The tester 101 carries out the electronic test of the DUT 108. A handler 106 comprises a transfer or plunger unit 107, which holds the electronic component 108. The handler 106 transfers and sorts the DUTs 108 after the test. The plunger unit 107 moves the electronic component 108 in the contacting direction 109 towards the contact socket 200. The contact socket 200 is fastened to a contact unit holder 103 (CUH). The contact unit holder 103 is fastened to a test head 102. A docking 105 couples the handler 106 and the test head 102.

Fig. 1B shows a schematic view of the contact unit holder 103 (CUH). Usually a plurality of 2, 4, 8, 12, 16 or more contact sockets 200 are used to enable the identical number of tests for DUTs 108 at the same time. The simultaneous test of DUTs 108 enables to test the plurality of DUTs 108 in a certain time period while only one handler 106 and one tester 101 is used.

Maintenance of one contact socket 200 does imply that also the other contact sockets 200 are not in action. Therefore, the time period for maintenance of a contact socket should be short.

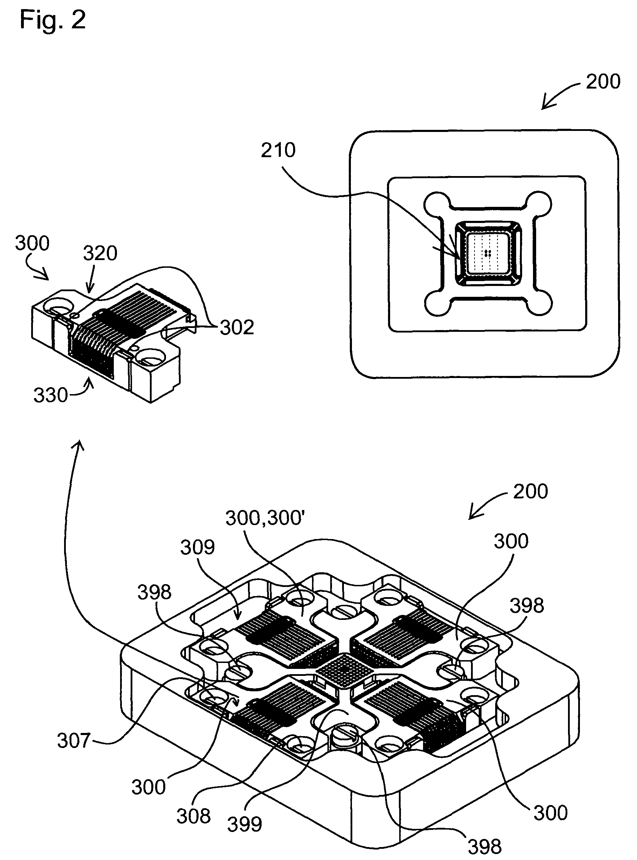

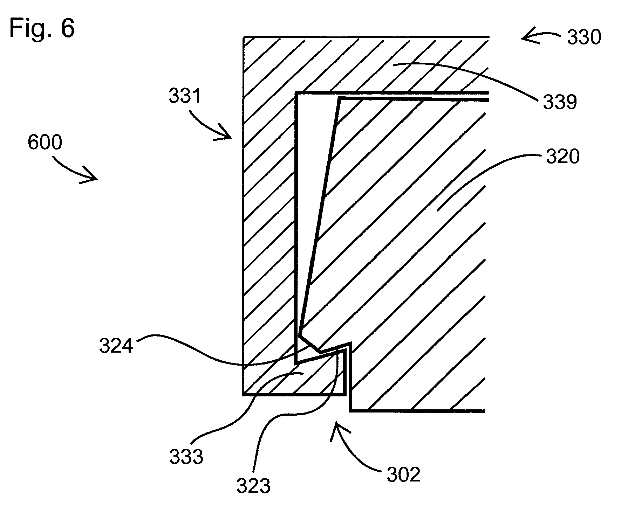

Fig. 2 shows perspective view of the back or bottom side of a contact socket 200, a perspective view of a contact spring block 300 and a plan view of the front or top side of the contact socket 200. Four contact spring blocks 300 are placed in mounting positions 309 each being located on one side of the contact socket 200. In a middle area of the front or top side of the contact socket 200 is the contact area, or so called "contact site" 210. The contact site 210 defines the functional part of the socket where the electronic component 108 is received to be electrically contacted. In the inner area of the contact site 210 a central contact block 399 is positioned in order to contact to pads of a DUT which are located in the middle area of the DUT 108. The central contact block 399 is fixed by four screws 398. The contact spring block 300 is fixed in the mounting position 309 by a first screw 307 and a second screw 308. A first contact spring block 300 may have the same size like a second, new or maintained contact spring block 300', so that an exchange of the contact spring block 300 is feasible. The contact spring block 300 comprises a base block 320 and a clip-on device 330 which are clipped together to form a clip-type connector 302 (also Fig. 6).

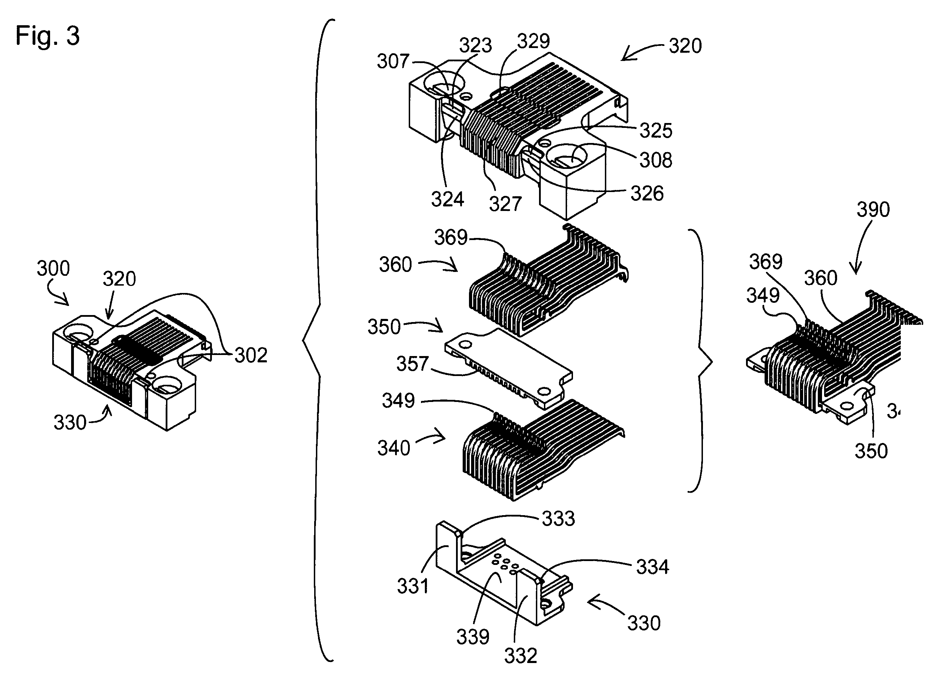

Fig. 3 again shows the perspective view of the contact spring block 300 comprising the clip-on element 330 and the base block 320 which together form the clip type connector 302. In the middle of Fig. 3 the contact spring block 300 is shown in an exploded view. The contact spring block 300 comprises in this order: the clip-on device 330, a group of single or individual contact springs 340, a distance plate 350, a further group of single contact springs 360 and the base block 320.

The base block 320 comprises a clip-in groove 323 and a further clip-in groove 325 engaging with a hook-like projection 333 and a further hook-like projection 334 of the clip-on device 334, respectively. The hook-like projection 333 and the further hook-like projection 334 are located at the outer end of a retaining clip 331 and a further retaining clip 332, respectively. The retaining clip 331 and the further retaining clip 332 extend in a perpendicular direction from a clip plate 339 being located in between the retaining clip 331 and the further retaining clip 332. The clip-on device 330 may be integrally formed from on plastic piece comprising at least two of the group of the clip plate 339, the retaining clip 333, and the further retaining clip 334. When the clip-on device 330 is clipped to the base block 320 the hook-like projection 333 of the retaining clip 331 glides over the chamfer 324 and clips into the clip-in groove 323. Similarly, the further hook-like projection 333 of the further retaining clip 331 glides over the further chamfer 324 and clips into the further clip-in groove 323, when the clip-on device 330 is clipped to the base block 320. The group of contact springs 340 and the further group of contact springs 360 have a typical S-form but of different dimensions so that the group of contact springs 340 surround the further group of contact springs 360. A distance plate 350 positioned between the group of contact springs 340 and the further group of contact springs 360 electrically separates the two groups of single contact springs 340, 360. The distance plate 350 comprises straight grooves 357 by which the group of contact springs 340 are aligned. The group of contact springs 340 has tester sided contacts 349 which provide an electrical contact to the tester 101 (see Fig. 1). Accordingly, the further group of contact springs 360 has further tester-sided contacts 369 which also provide an electrical contact to the tester 101. The further group of contact springs 360 fit into curved grooves 327 of the base block 320 and are aligned and electrically isolated from each other by the curved grooves 327. The base block 320 comprises a recess 329 for the end portions of the group of contact springs 340 and of the further group of contact springs 360 so that the tester sided contacts 349 and the further tester sided contacts 369 are resilient or elastically clamped in a zone of the recess 329. This provides adaptable contacting to the tester 101.

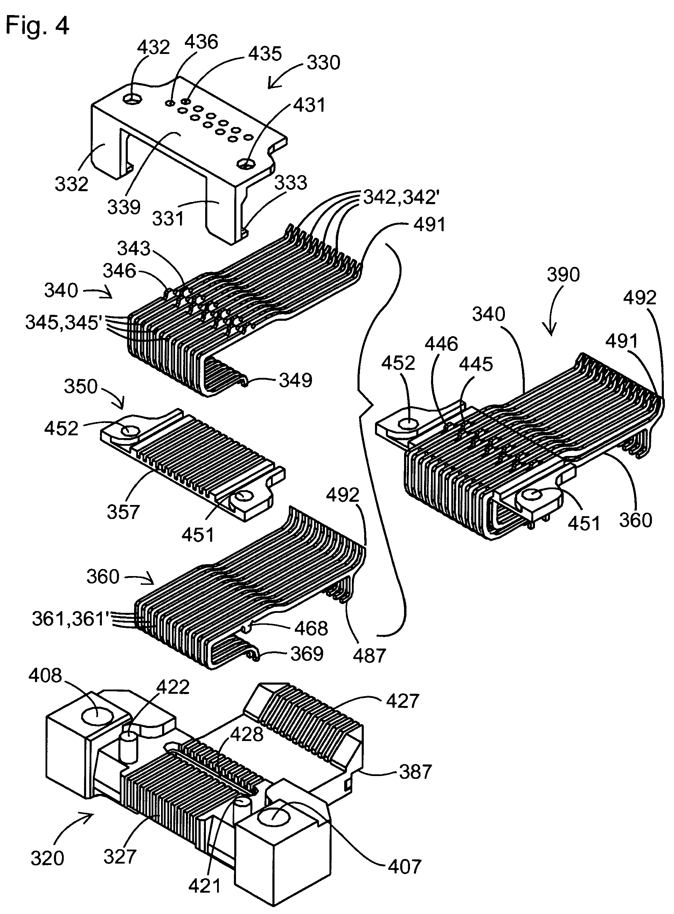

Fig. 4 shows a 180°-turned perspective view of the contact spring block 300 compared to Fig. 3. Hence, Fig. 4 shows the contact spring block 300 from the top or front side with contact tips 491, 492 upwards.

The clip plate 339 extending between the retaining clip 331 and the further retaining clip 332 comprises first alignment holes 435 and second alignment holes 436. The first alignment holes 435 are located closer to the contact tip ends 491, 492 than the second alignment holes 436. Hence, the first alignment holes 435 and the second alignment holes 436 form a zig-zag pattern on the clip plate 339. As a consequence, the clip plate 339 is more stable with this zig-zag pattern. Further, the first alignment pins 343 and the second alignment pins 346 are distanced from the contact tips 491, in a way, so that the contact tips 491 of the group of contact springs 340 are aligned in a straight row by an engagement of the first alignment pins 343 with the first alignment holes 435 and of the second alignment pins 346 with the second alignment holes 436. So, the group of single contact springs 340 comprises a first subgroup of a first contact spring type 342 wherein each single contact spring 342' of this type has the first alignment pin 343. Further, the group of single contact springs 340 comprises a second subgroup of a first contact spring type 345 wherein each single contact spring 345' of this type has the second alignment pin 346. A single contact spring of the first type 342 is, therefore, exchangeable by second contact spring 342' of the same type. Analogously, a single contact spring of the second type 345 is, therefore, exchangeable by second contact spring 345' of the same type.

The clip-on device 330 comprises a clip mounting hole 431 and a further clip mounting hole 432 which engage with the mounting pin 421 and the further mounting pin 422 of the base block 320. As a consequence, the clip-on device 330 cannot fall off the base block 320 in a perpendicular direction when both are clipped together. The curved parts of the further group of contact springs 360 go around the curved grooves 327 of the base block 320 and are electrically isolated. A base mounting pin 468 extends from the further contact springs 360 towards a mounting groove 428 of the base block 320, so that the further group of single contact springs 360 are aligned. The base block 320 comprises a first screw hole 407 and a second screw hole 408 for the first screw 307 and the second screw 308, respectively.

The distance plate 350 comprises a distance plate mounting hole 451 and a further distance plate mounting hole 452 which prevent the distance plate 450 from falling off the base block 320 when engaged with the mounting pins 431 and 432, respectively. This is similar to the mechanism how the clip-on device 330 is secured at the base block 320.

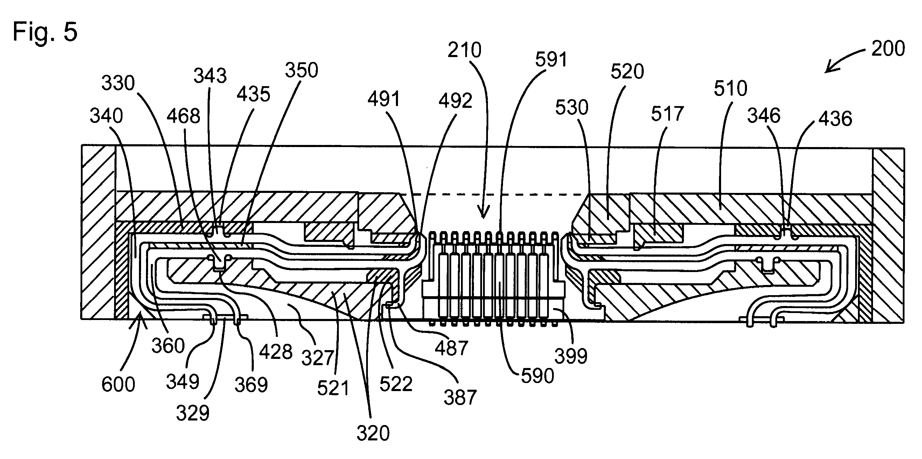

A contact spring arrangement 390 (also shown in Fig. 3) comprises the group of contact springs 340, the distance plate 350 and the further group of contact springs 360. The group of contact springs 340 and the further group of contact springs 360 are arranged above each other and are electrically separated by the distance plate 350. The group of contact springs 340 and the further group of contact springs 360 are extending along elastic sections towards their contact tips 491 and further contact tips 492. Each of the group of contact springs 340 and the further group of contact springs 360 is arranged in straight rows side by side so that the contact tips 491 and the further contact tips 492 form a straight line of electrically isolated contact springs. A single contact spring of the further group of contact springs 361 is exchangeable by second single contact spring 361' of this further group of contact springs 360. Fig. 5 shows a cross-sectional view of the contact socket 200. A detail 600 in Fig. 5 is shown in Fig. 6 in more detail. The group of contact springs 340 goes around the further group of contact springs 360 and the two groups of single contact springs 340, 360 are separated by the distance plate 350. The group of contact springs 340 is aligned by means of the clip-on device 330 and by the engagement of the first alignment pin 343 and the first alignment hole 435 on the left side of the contact socket 200. On the opposite, right side of the contact socket 200 the group of contact springs 340 is aligned by the engagement of the second alignment pin 343 and the second alignment hole 435. The further group of contact springs is aligned by the base mounting pin 468 and the mounting groove 428 of the base block 428.

On one side the contact springs end in recess 329 where the tester sided contacts 349 and the further tester sided contacts 369 are contacted. On the opposite side, the contact springs end with the contact tips 491 and further contact tips 492 and provide a so called Kelvin contact. The contact springs 340, 360 are embedded in the curved grooves 327 of the base block 320. The base block 320 may be composed from a front block 522 and center block 521 wherein the front block 522 provides a guided movement of contact tips 491, 492. With a front hook 487 and a front edge 387 the movement of the further contact springs 360 is upwardly limited wherein "upwardly" means "in the direction of the contact tips". The upper movement of the contact springs 340 is upwardly limited by an abutting plate 530 which is fixed to a centering frame 520 comprising a slope or flank for guiding the DUT 108. The centering frame 520 is fixed to a socket frame 510. Furthermore, an upper guiding 517 is fixed to the centering frame 520 in order to guide the elastic movement of the group of contact springs 340.

The contact site 210 is located in the middle of the contact socket 200. The central contact block 399 comprises a stack of pogo pins 590 which have pogo pin tips 591 to contact with inner contact portions of the DUT 108.

Fig 6 shows a cross-sectional view of a clip type connector 302 as a detail 600 of Fig. 5.

The clip-on device 330 is clipped to the base block 320 by a retaining clip 331. If the hook-like projection 333 glides over the chamfer 324 and rests in the clip-in groove 323 a clip type connector 302 is given. On the opposite side of the hook-like projection 333 the clip-on element 330 rests with the clip plate 339 on the base block 320 in order to exert the clamp force.

## Claims

1. A contact spring block (300) for a sequential test of electronic components (108), comprises:
a base block (320),
a group of single contact springs (340),
and a clip-on device (330),
wherein
the clip-on device (330) is fastenable to the base block (320) by clipping the clip-on device (330) to the base block (320), and wherein
the group of single contact springs (340) is clamped and aligned when the clip-on device (330) is clipped to the base block (320).

2. The contact spring block (300) according to claim 1, wherein
the group of single contact springs (340) comprises
a first subgroup of a first contact spring type (342), wherein each single contact spring of the first contact spring type has a first alignment pin (343), and
a second subgroup of a second contact spring type (345)), wherein each single contact spring of the second contact spring type has a second alignment pin (346), wherein
at least one single contact spring of the first type (342) or of the second type (345) comprises a contact tip (491), wherein
a first type contact spring (342) and a second type contact spring (345) are clamped adjacently and wherein
a distance from the contact tip (491) to the first alignment pin (343) is smaller than a distance from the contact tip (491) to the second alignment pin (346).

3. The contact spring block (300) according to claim 2, further comprises a clip plate (339) having a first alignment hole (435) and a second alignment hole (436), wherein
the first alignment hole (435) engages with the first alignment pin (343) and the second alignment hole (436) engages with the second alignment pin (346).

4. The contact spring block (300) according to any one of the claims 1 to 3,
wherein
the base block (320) comprises a clip-in groove (323), and wherein the clip-on device (330) comprises a retaining clip (331) having a hook-like projection (333), and wherein
the clip-on device (330) and the base block (320) are clipped together by an engagement of the clip-in groove (323) and the hook-like projection (333).

5. The contact spring block (300) according to claim 4, wherein
the base block (320) comprises a further clip-in groove (325), and the clip-on device (330) comprises a further retaining clip (332) having a further hook-like projection (334), wherein
the clip-on device (330) and the base block (320) are clipped together by an engagement of the further clip-in groove (325) and the further hook-like projection (334).

6. The contact spring block (300) according to claim 5, wherein
the retaining clip (331) and the further retaining clip (332) project in the same direction from opposite side sections of the clip plate (339).

7. The contact spring block (300) according to claims 5 or 6, wherein
the first alignment hole (435) and the second alignment hole (436) are located between the retaining clip (331) and the further retaining clip (332).

8. The contact spring block (300) according to any one of the claims 3 to 7,
wherein
the clip-on device (330) is integrally formed from one piece and comprises at least two elements out of the group consisting of the clip plate (339), the retaining clip (331) and the further retaining clip (332).

9. The contact spring block (300) according to any one of the claims 1 to 8,
wherein
the base block (320) comprises a chamfer (324) by which the retaining clip (331) is pre-stressed when clipping the clip-on device (330) to the base block (320).

10. The contact spring block (300) according to any one of the claims 1 to 8,
wherein
the base block (320) comprises a mounting pin (421) and wherein
the clip-on device (330) comprises a clip mounting hole (431), and wherein
the clip-on device (330) is fixed by an engagement of the mounting pin (421) and the clip mounting hole (431) in a direction perpendicular to a clamp force.

11. The contact spring block (300) according to claims 1 to 10, further
comprising
a further group of contact springs (360) and a distance plate (350), wherein
the distance plate (350) is arranged between the group of contact springs (340) and the further group of contact springs (360).

12. The contact spring block (300) according to claim 11 wherein
the distance plate (350) comprises a distance plate mounting hole (451) and wherein
the distance plate (350) is fixed by an engagement of the mounting pin (421) and the distance plate mounting hole (451).

13. A contact socket (200) comprises:
a contact site (210) and a number of contact spring blocks (300) according claims 1 to 12 wherein
each of the contact spring blocks (300) is arranged in a mounting position (309) on a side section of the contact site (210), and wherein
the contact site (210) is a central area of the contact socket (200), in which the electronic components (108) are pressable.

14. A method of changing contact springs (342, 345, 361) of a contact spring
block (300) the method comprising:
Removing a clip-on device (330) from a base block (320),
Removing a first contact spring (342, 345, 361) of a group of single contact springs (340, 360) of the contact spring block (300) and putting a second contact spring (342', 345', 361') in the position of the first contact spring (342, 345, 361),
Clipping the clip-on device (330) to the base block (320) so that the group of single contact springs (340', 360') comprising the second contact spring (342', 345', 361') is clamped.

15. The method of changing contact springs (342, 345, 361) of a contact
socket (200) according to claim 14 the method further comprising:
Removing a first contact spring block (300) comprising the first contact spring (342, 345, 361) from a mounting position (309),
Putting a second contact spring block (300') comprising the second contact spring (342', 345', 361') in the mounting position (309).

## Patentansprüche

1. Ein Kontaktfederblock (300) zum sequentiellen Testen von elektronischen Komponenten (108), aufweisend:
einen Basisblock (320),
eine Gruppe einzelner Kontaktfedern (340) und
eine Ansteckvorrichtung (330), wobei
die Ansteckvorrichtung (330) an dem Basisblock (320) mittels Ansteckens der Ansteckvorrichtung (330) an dem Basisblock (320) befestigbar ist, und wobei die Gruppe einzelner Kontaktfedern (340) geklemmt und ausgerichtet ist, wenn die Ansteckvorrichtung (330) an den Basisblock (320) angesteckt ist.

2. Der Kontaktfederblock (300) gemäß Anspruch 1, wobei die Gruppe einzelner Kontaktfedern (340) aufweist
eine erste Untergruppe von einer ersten Kontaktfederart (342), wobei jede einzelne Kontaktfeder der ersten Kontaktfederart einen ersten Führungsstift (343) hat, und
eine zweite Untergruppe von einer zweiten Kontaktfederart (345), wobei jede einzelne Kontaktfeder der zweiten Kontaktfederart einen zweiten Führungsstift (346) hat, wobei
zumindest eine einzelne Kontaktfeder der ersten Art (342) oder der zweiten Art (345) eine Kontaktspitze (491) aufweist, wobei
eine erste Art Kontaktfeder (342) und eine zweite Art Kontaktfeder (345) aneinandergrenzend geklemmt sind, und wobei
ein Abstand von der Kontaktspitze (491) zu dem ersten Führungsstift (343) kleiner ist als ein Abstand von der Kontaktspitze (491) zu dem zweiten Führungsstift (346).

3. Der Kontaktfederblock (300) gemäß Anspruch 2 weist ferner auf eine Steckplatte (339), welche ein erstes Führungsloch (435) und ein zweites Führungsloch (436) hat, wobei
das erste Führungsloch (435) mit dem ersten Führungsstift (343) eingreift und das zweite Führungsloch (436) mit dem zweiten Führungsstift (346) eingreift.

4. Der Kontaktfederblock (300) gemäß einem beliebigen der Ansprüche 1 bis 3, wobei
der Basisblock (320) eine Einstecknut (323) aufweist, und wobei die Ansteckvorrichtung (330) einen Rückhalteclip (331) aufweist, welcher einen hakenartigen Überstand (333) hat, und wobei
die Ansteckvorrichtung (330) und der Basisblock (320) zusammengesteckt sind mittels eines Eingreifens der Einstecknut (323) und des hakenartigen Überstandes (333).

5. Der Kontaktfederblock (300) gemäß Anspruch 4, wobei
der Basisblock (320) eine weitere Einstecknut (325) aufweist, und die Ansteckvorrichtung (330) einen weiteren Rückhalteclip (332) aufweist, welcher einen weiteren hakenartigen Überstand (334) hat, wobei
die Ansteckvorrichtung (330) und der Basisblock (320) zusammengesteckt sind mittels eines Eingreifens der weiteren Einstecknut (325) und des weiteren hakenartigen Überstandes (334).

6. Der Kontaktfederblock (300) gemäß Anspruch 5, wobei
der Rückhalteclip (331) und der weitere Rückhalteclip (332) in dieselbe Richtung hervorstehen von entgegengesetzten Seitenabschnitten der Steckplatte (339).

7. Der Kontaktfederblock (300) gemäß Ansprüchen 5 oder 6, wobei
das erste Führungsloch (435) und das zweite Führungsloch (436) zwischen dem Rückhalteclip (331) und dem weiteren Rückhalteclip (332) festgelegt sind.

8. Der Kontaktfederblock (300) gemäß einem beliebigen der Ansprüche 3 bis 7, wobei
die Ansteckvorrichtung (330) integral aus einem Stück geformt ist und zumindest zwei Elemente aufweist aus der Gruppe bestehend aus der Steckplatte (339), dem Rückhalteclip (331) und dem weiteren Rückhalteclip (332).

9. Der Kontaktfederblock (300) gemäß einem beliebigen der Ansprüche 1 bis 8, wobei
der Basisblock (320) eine Fase (324) aufweist, mittels welcher der Rückhalteclip (331) vorgespannt ist, wenn die Ansteckvorrichtung (330) an den Basisblock (320) gesteckt ist.

10. Der Kontaktfederblock (300) gemäß einem beliebigen der Ansprüche 1 bis 8, wobei
der Basisblock (320) einen Befestigungsstift (421) aufweist, und wobei die Ansteckvorrichtung (330) ein Clipbefestigungsloch (431) aufweist, und wobei die Ansteckvorrichtung (330) fixiert ist mittels eines Eingreifens des Befestigungsstiftes (421) und des Clipbefestigungslochs (431) in eine Richtung rechtwinklig zu einer Klemmkraft.

11. Der Kontaktfederblock (300) gemäß den Ansprüchen 1 bis 10, ferner aufweisend
eine weitere Gruppe Kontaktfedern (360) und eine Abstandsplatte (350), wobei die Abstandsplatte (350) zwischen der Gruppe Kontaktfedern (340) und der weiteren Gruppe Kontaktfedern (360) angeordnet ist.

12. Der Kontaktfederblock (300) gemäß Anspruch 11, wobei die Abstandsplatte (350) ein Abstandsplattenbefestigungsloch (451) aufweist, und wobei
die Abstandsplatte (350) mittels eines Eingreifens des Befestigungsstifts (421) und des Abstandsplattenbefestigungslochs (451) fixiert ist.

13. Eine Kontaktbuchse (200), aufweisend:
einen Kontaktort (210) und eine Anzahl von Kontaktfederblöcken (300) gemäß den Ansprüchen 1 bis 12, wobei
jeder der Kontaktfederblöcke (300) in einer Befestigungsposition (309) an einem Seitenabschnitt des Kontaktorts (210) angeordnet ist, und Wobei der Kontaktort (210) ein Mittelbereich der Kontaktbuchse (200) ist, in welchen die elektronischen Komponenten (108) pressbar sind.

14. Ein Verfahren zum Wechseln von Kontaktfedern (342, 345, 361) eines Kontaktfederblocks (300), wobei das Verfahren aufweist:
Entfernen einer Ansteckvorrichtung (330) von einem Basisblock (320),
Entfernen einer ersten Kontaktfeder (342, 345, 361) einer Gruppe von einzelnen Kontaktfedern (340, 360) des Kontaktfederblocks (300) und Anbringen einer zweiten Kontaktfeder (342', 345', 361') an der Position der ersten Kontaktfeder (342, 345, 361),
Stecken der Ansteckvorrichtung (330) an den Basisblock (320), so dass die Gruppe einzelner Kontaktfedern (340', 360') geklemmt wird, welche die zweiten Kontaktfedern (342', 345', 361') aufweist.

15. Das Verfahren zum Wechseln von Kontaktfedern (342, 345, 361) einer Kontaktbuchse (200) gemäß Anspruch 14, wobei das Verfahren ferner aufweist:
Entfernen eines ersten Kontaktfederblocks (330), welcher die erste Kontaktfeder (342, 345, 361) aufweist, von einer Befestigungsposition (309),
Anbringen eines zweiten Kontaktfederblocks (300'), welcher die zweite Kontaktfeder (342', 345', 361') aufweist, an der Befestigungsposition (309).

## Revendications

1. Bloc à ressort de contact (300) pour un essai séquentiel de composants électroniques (108), comprenant :
un bloc de base (320),
un groupe de ressorts de contact unique (340),
et un dispositif à attache par clip (330),
dans lequel
le dispositif à attache par clip (330) peut être fixé au bloc de base (320) en attachant par clip le dispositif à attache par clip (330) au bloc de base (320), et dans lequel
le groupe de ressorts de contact unique (340) est serré et aligné lorsque le dispositif à attache par clip (330) est attaché par clip au.bloc de base (320).

2. Bloc à ressort de contact (300) selon la revendication 1, dans lequel
le groupe de ressorts de contact unique (340) comprend
un premier sous-groupe d'un premier type de ressort de contact (342), dans lequel chaque ressort de contact unique du premier type de ressort de contact possède une première goupille d'alignement (343), et
un second sous-groupe d'un second type de ressort de contact (345), dans lequel chaque ressort de contact unique du second type de ressort de contact possède une seconde goupille d'alignement (346), dans lequel
au moins un ressort de contact unique du premier type (342) ou du second type (345) comprend un embout de contact (491), dans lequel
un ressort de contact de premier type (342) et un ressort de contact de second type (345) sont serrés de façon adjacente et dans lequel
une distance de l'embout de contact (491) à la première goupille d'alignement (343) est plus petite qu'une distance de l'embout de contact (491) à la seconde goupille d'alignement (346).

3. Bloc à ressort de contact (300) selon la revendication 2, comprenant en outre une plaque à clip (339) possédant un premier trou d'alignement (435) et un second trou d'alignement (436), dans lequel
le premier trou d'alignement (435) entre en prise avec la première goupille d'alignement (343) et le second trou d'alignement (436) entre en prise avec la seconde goupille d'alignement (346).

4. Bloc à ressort de contact (300) selon l'une quelconque des revendications 1 à 3, dans lequel
le bloc de base (320) comprend une rainure réceptrice de clip (323), et dans lequel le dispositif à attache par clip (330) comprend un clip de retenue (331) possédant une saillie en forme de crochet (333), et dans lequel
le dispositif à attache par clip (330) et le bloc de base (320) sont attachés ensemble par clip par une entrée en prise de la rainure réceptrice de clip (323) et de la rainure en forme de crochet (333).

5. Bloc à ressort de contact (300) selon la revendication 4, dans lequel
le bloc de base (320) comprend une rainure réceptrice de clip supplémentaire (325), et le dispositif à attache par clip (330) comprend un clip de retenue supplémentaire (332) possédant une saillie en forme de crochet supplémentaire (334), dans lequel
le dispositif à attache par clip (330) et le bloc de base (320) sont attachés ensemble par clip par une entrée en prise de la rainure réceptrice de clip supplémentaire (325) et la saillie en forme de crochet supplémentaire (334).

6. Bloc à ressort de contact (300) selon la revendication 5, dans lequel
le clip de retenue (331) et le clip de retenue supplémentaire (332) font saillie dans la même direction à partir de sections latérales opposées de la plaque à clip (339).

7. Bloc à ressort de contact (300) selon les revendications 5 ou 6, dans lequel
le premier trou d'alignement (435) et le second trou d'alignement (436) sont situés entre le clip de retenue (331) et le clip de retenue supplémentaire (332).

8. Bloc à ressort de contact (300) selon l'une quelconque des revendications 3 à 7, dans lequel
le dispositif à attache par clip (330) est formé de façon monobloc à partir d'une pièce et comprend au moins deux éléments parmi le groupe constitué de la plaque à clip (339), du clip de retenue (331) et du clip de retenue supplémentaire (332).

9. Bloc à ressort de contact (300) selon l'une quelconque des revendications 1 à 8, dans lequel
le bloc de base (320) comprend un chanfrein (324) par lequel le clip de retenue (331) est précontraint lors de l'attache par clip du dispositif à attache par clip (330) au bloc de base (320).

10. Bloc à ressort de contact (300) selon l'une quelconque des revendications 1 à 8, dans lequel
le bloc de base (320) comprend une goupille de montage (421) et dans lequel
le dispositif à attache par clip (330) comprend un trou de montage de clip (431), et dans lequel
le dispositif à attache par clip (330) est fixé par une entrée en prise de la goupille de montage (421) et du trou de montage de clip (431) dans une direction perpendiculaire à une force de serrage.

11. Bloc à ressort de contact (300) selon les revendications 1 à 10, comprenant en outre
un groupe supplémentaire de ressorts de contact (360) et une plaque entretoise (350), dans lequel la plaque entretoise (350) est agencée entre le groupe de ressorts de contact (340) et le groupe supplémentaire de ressorts de contact (360).

12. Bloc à ressort de contact (300) selon la revendication 11 dans lequel
la plaque entretoise (350) comprend un trou de montage de plaque entretoise (451) et dans lequel
la plaque entretoise (350) est fixée par une entrée en prise de la goupille de montage (421) et le trou de montage de plaque entretoise (451).

13. Support de contact (200), comprenant :
un site de contact (210) et un nombre de blocs à ressort de contact (300) selon les revendications 1 à 12, dans lequel
chacun des blocs à ressort de contact (300) est agencé dans une position de montage (309) sur une section latérale du site de contact (210), et dans lequel
le site de contact (210) est une zone centrale du support de contact (200), dans laquelle les composants électroniques (108) peuvent être pressés.

14. Procédé de changement de ressorts de contact (342, 345, 361) d'un bloc à ressort de contact (300), le procédé comprenant :
l'enlèvement d'un dispositif à attache par clip (330) à partir d'un bloc de base (320),
l'enlèvement d'un premier ressort de contact (342, 345, 361) d'un groupe de ressorts de contact unique (340, 360) du bloc à ressort de contact (300) et le placement d'un second ressort de contact (342', 345', 361') dans la position du premier ressort de contact (342, 345, 361),
l'attache par clip du dispositif à attache par clip (330) au bloc de base (320) pour que le groupe de ressorts de contact unique (340', 360') comprenant le second ressort de contact (342', 345', 361') soit serré.

15. Procédé de changement de ressorts de contact (342, 345, 361) d'un support de contact (200) selon la revendication 14, le procédé comprenant en outre :
l'enlèvement d'un premier bloc à ressort de contact (300) comprenant le premier ressort de contact (342, 345, 361) à partir d'une position de montage (309),
le placement d'un second bloc à ressort de contact (300') comprenant le second ressort de contact (342', 345', 361') dans la position de montage (309).
